(19) Europäisches Patentamt
European Patent Office
Office européen des brevets

(11) EP 0 580 947 B1

# (12) EUROPÄISCHE PATENTSCHRIFT

(45) Veröffentlichungstag und Bekanntmachung des Hinweises auf die Patenterteilung:
**27.05.1998 Patentblatt 1998/22**

(51) Int Cl.⁶: **G01R 27/26**, H04M 3/30

(21) Anmeldenummer: **93104256.8**

(22) Anmeldetag: **16.03.1993**

(54) **Verfahren zum Ermitteln einer elektrischen Kenngrösse**

Method for measuring electrical quantities

Procédé pour déterminer des grandeurs électriques

(84) Benannte Vertragsstaaten:
**AT BE CH DE DK ES FR GB GR IT LI LU NL SE**

(30) Priorität: **31.03.1992 DE 4210621**

(43) Veröffentlichungstag der Anmeldung:
**02.02.1994 Patentblatt 1994/05**

(73) Patentinhaber: **SIEMENS AKTIENGESELLSCHAFT
80333 München (DE)**

(72) Erfinder:
- **Gnan, Günther, Dipl.-Ing.
  W-8038 Gröbenzell (DE)**
- **Kaiser, Wolfgang, Dipl.-Ing. (FH)
  W-8228 Freilassing (DE)**
- **Preiss, Frank, Dipl.-Phys.
  W-8080 Fürstenfeldbruck (DE)**
- **Schmutzler, Werner
  W-8080 Fürstenfeldbruck (DE)**

(56) Entgegenhaltungen:
EP-A- 0 033 858          US-A- 4 186 282
US-A- 5 073 920

## Beschreibung

Bei der Entstörung von Teilnehmeranschlüssen werden in Vermittlungsstellen Prüfeinrichtungen zur Lokalisierung der Fehlerstellen eingesetzt.

Eine Aufgabe der Prüfeinrichtungen ist es, die Kapazität und den Widerstand der Teilnehmeranschlußleitung zu messen. Das Meßobjekt "Teilnehmeranschlußleitung" besteht hierbei aus einem Netzwerk, in dem beide Kenngrößen gleichzeitig vorkommen. Zusätzlich treten Fremdspannungen auf, die durch schlechte Isolation zu Nachbarleitungen und durch Induktion von Energieversorgungsleitungen entstehen. Unterschiedliche Endgeräte erfordern des weiteren die Verwendung von mehreren Meßspannungen.

Bisher wurden für die Kapazitätsmessung und für die Widerstandsmessung eigene Meßkreise entwickelt, die im Prüffeld abgeglichen wurden und deren Genauigkeit während des Betriebes von der Alterung der verwendeten Bauteile abhängig war. Konnte damit eine neu auftretende Meßanforderung nicht mehr erfüllt werden, so wurde eine Variante entwickelt.

Einige Beispiele von Prüfeinrichtungen von Teilnehmeranschlüssen sind aus den Dokumenten US-A-5073920, US-A-4186282 und EP-A-0033858 bekannt.

Der Erfindung liegt das Problem zugrunde, ein Verfahren anzugeben, durch das die elektrischen Kenngrößen eines Meßobjekts störungsfrei ermittelt werden können.

Dieses Problem wird durch ein Verfahren gemäß Anspruch 1 gelöst.

Durch die erfindungsgemäße Aufspaltung der Messung in zwei Teile mit unterschiedlicher Polarität der gemessenen Meßgröße wird der störende Einfluß einer eingekoppelten Gleichspannung eliminiert.

Eine Ausführungsform der Erfindung gemäß Anspruch 5 beinhaltet insbesondere den Vorteil, daß der störende Einfluß einer eingekoppelten Wechselspannung bei der Widerstandsermittlung eliminiert wird.

Eine Ausführungsform der Erfindung gemäß Anspruch 6 beinhaltet insbesondere den Vorteil, daß der störende Einfluß einer eingekoppelten Wechselspannung bei der Kapazitätsermittlung eliminiert wird.

Es folgt die Figurenliste:

Figur 1 zeigt eine Meßschaltung zur Durchführung des erfindungsgemäßen Verfahrens sowie eine Ersatzschaltung des Meßobjekts.

Figur 2 zeigt den zeitlichen Verlauf der Meßspannung während der Messung.

Im folgenden wird ein Ausführungsbeispiel der Erfindung anhand der Zeichnung näher erläutert. Als Meßobjekt ist dabei eine Teilnehmeranschlußleitung vorausgesetzt.

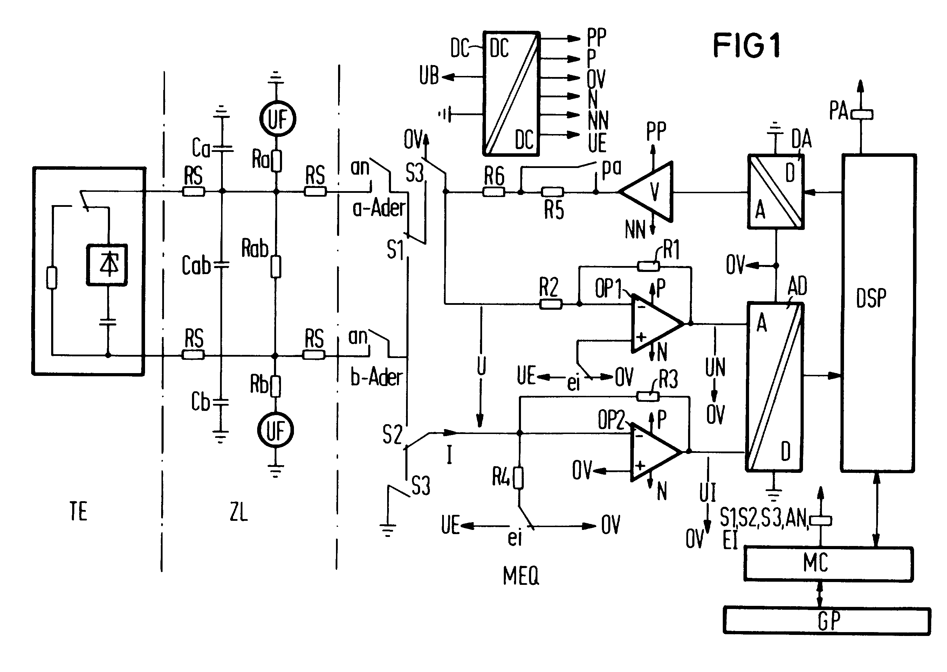

Figur 1 zeigt eine Meßschaltung MEQ zur Durchführung des erfindungsgemäßen Verfahrens sowie eine Ersatzschaltung des Meßobjekts. Die Ersatzschaltung besteht aus einem vereinfacht dargestellten Eingangskreis eines Telefons TE und einem Ersatzschaltbild für eine Zweidrahtleitung ZL in einem Telefonkabel.

Das Ersatzschaltbild der Zweidrahtleitung ZL umfaßt einen ohm'schen Widerstand RS des Kupferdrahtes, Isolationswiderstände Ra, Rb, und Rab zu den Nachbaradern, eine Fremdspannung UF, die sich wegen mangelnder Isolation zu den Nachbaradern einstellen kann oder die durch Induktion mit Energieversorgungsleitungen entsteht, sowie Kapazitäten Ca, Cb und Cab gegenüber Erde und zwischen der a- und b-Ader.

Die Meßschaltung MEQ zur Durchführung des erfindungsgemäßen Verfahrens umfaßt einen DC/DC-Wandler DC, einen D/A-Wandler DA, einen A/D-Wandler AD, einen Verstärker V, eine Spannungsmeßschaltung OP1, eine Strommeßschaltung OP2, einen Mikrocomputer MC, einen Signalprozessor DSP sowie verschiedene Relais AN, EI, S1, S2, S3.

Der DC/DC-Wandler stellt an seiner Sekundärseite die Versorgungsspannungen für die Meßkreise zur Verfügung. Die Versorgungsspannungen haben keinen Erdbezug, sie sind auf den potentialfreien OV-Ausgang bezogen. P und N sind die Versorgungsspannungen für die Spannungsmeßschaltung OP1, die Strommeßschaltung OP2 und den A/D- bzw. D/A-Wandler. PP und NN sind die Versorgungsspannungen für den Verstärker V. UE is die Eichspannungsquelle. Die Primärseite des DC/DC- Wandlers wird von Erde und Amtsbatterie UB gespeist.

Der D/A-Wandler setzt die vom Signalprozessor DSP gelieferten digitalen und auf Erde bezogenen Spannungswerte in analoge und auf OV bezogene Spannungswerte für den Verstärker V um.

Der A/D-Wandler setzt die analogen und auf OV bezogenen Spannungswerte UN und UI in digitale und auf Erde bezogene Spannungswerte für den Signalprozessor um.

Der Verstärker V liefert die Amplitude und den Strom für die Meßspannung U. Ein Widerstand R5 dient beim Anschalten der Sendeschaltung an das Meßobjekt als hochohmiger Schutzwiderstand. Der Widerstand R6 wirkt im Falle eines Kurzschlusses während der Messung als Strombegrenzungswiderstand. Der Verstärker V arbeitet im Spannungsbereich der Amtsbatterie von O bis +/ - 60 V. Damit kann die Meßschaltung MEQ durch eingekoppelte Gleichspannung nicht übersteuert werden.

Die Spannungsmeßschaltung OP1 skaliert die Meßspannung U am Meßobjekt auf den Arbeitsbereich des A/D-Wandlers. Die Spannungsmeßschaltung besteht aus einem invertierenden Verstärker und den Widerständen R1 und R2. Sie hat drei Betriebszustände, nämlich einen Ruhezustand, einen Eichzustand und einen Meßzustand.

Im Ruhezustand speichert der Signalprozessor DSP den Offset- Wert für den Nullpunkt, d.h. für U = OV abv. Dabei gilt für die normierte Meßspannung UN: UN = - U * R1/R2. Im Eichzustand mißt der Signalprozessor den Wert für die Eichspannung UE und berechnet daraus den Eichfaktor, der ebenfalls abgespeichert wird. Dabei gilt für die normierte Meßspannung: UN = UE (1 + R1/R2) und für den Eichfaktor:

$$EF = UE(Nennwert)/UE(Meßwert).$$

Im Meßzustand gilt für die normierte Meßspannung:

$$UN = - U * R1/R2.$$

Die Strommeßschaltung OP2 nimmt den Meßstrom I auf, der vom Verstärker V geliefert wird. Dabei stellt der negative Eingang der Strommeßschaltung einen viruellen OV-Bezugspunkt dar, so daß durch die Strommeßschaltung selbst kein Spannungsabfall im Meßkreis auftritt. Der Meßstrom I fließt über den Widerstand R3 zum Ausgang der Strommeßschaltung, wodurch die proportionale Spannung UI entsteht. Die proportionale Spannung UI ist proportional zum Meßstrom I und ist durch geeignete Dimensionierung des Widerstandes R3 auf den Arbeitsbereich des A/D-Wandlers skaliert.

Die Strommeßschaltung hat drei Betriebszustände, nämlich einen Ruhezustand, einen Eichzustand und einen Meßzustand.

Im Ruhezustand speichert der Signalprozessor den Offset-Wert für den Nullpunkt, d.h. für I = O ab. Dabei gilt für die proportionale Spannung: UI = - I* R3.

Im Eichzustand mißt der Signalprozessor den Wert für die Eichspannung UE und berechnet daraus den Eichfaktor, der ebenfalls abgespeichert wird. Dabei gilt für die proportionale Spannung: UI = - UE * R3/R4 und für den Eichfaktor

$$EF = UE(Nennwert)/UE(Meßwert).$$

Im Meßzustand gilt für die Proportionalspannung:

$$UI = - I * R3.$$

Der Mikrocomputer MC erhält von einer übergeordneten Steuerung GP Meßaufträge und sendet die Meßergebnisse dazu an sie zurück. Zum Messen stellt er die Relais S1, S2, S3, AN und EI entsprechend ein und aktiviert den Signalprozessor DSP. Dabei wird das zum Messen vom Signalprozessor benötigte Programm vom Mikrocomputer in den RAM-Speicher des Signalprozessors geladen. Dies ermöglicht, daß das Steuerprogramm für den Mikrocomputer und die Signalprozeß-Programme für den Signalprozessor in einem zentralen EPROM-Speicher untergebracht werden können. Dies verringert die Kosten, da der Signalprozessor wegen seiner hohen Taktrate schnelle und daher teure EPROM-Speicher benötigt. Bei einem Firmwaretausch muß daher nur ein EPROM ausgetauscht werden. In einem an die zulässige Temperaturänderung des Systems angepaßten Zeitraster startet der Mikrocomputer einen Eichvorgang zum Abgleich der Meßkreise.

Der Signalprozessor DSP ermittelt die Meßergebnisse für den Widerstand RX und die Kapazität CX der Teilnehmeranschlußleitung. Dazu liest er die digitalisierten Spannungswerte UN und UI ein, erzeugt daraus die Meßsignale U und I und berechnet die Meßwerte für den Widerstand und die Kapazität. Dabei wird jeder Meßwert von UN und UI in zwei Stufen korrigiert. Im ersten Schritt wird der beim Eichvorgang abgespeicherte Offset-Wert für den Nullpunkt subtrahiert, im zweiten Schritt wird der Meßwert mit dem ebenfalls abgespeicherten Eichfaktor multipliziert. Dadurch entfällt ein Abgleich der Meßschaltung im Prüffeld. Mit dem Relais PA wird der Schutzwiderstand R5 während des Messens überbrückt.

Die Anschaltung der Meßschaltung an das Meßobjekt erfolgt über Relais. Die für die verwendeten Betriebszustände der Meßschaltung notwendigen Einstellungen der Relais sind in der nachfolgenden Tabelle beschrieben.

| AN | EI | S1 | S2 | S3 | Betriebszustand |
|---|---|---|---|---|---|
| 0 | 0 | 0 | 0 | 0 | Ruhezustand |
| 0 | 1 | 0 | 0 | 0 | Eichzustand |

(fortgesetzt)

| AN | EI | S1 | S2 | S3 | Betriebszustand |
|----|----|----|----|----|------------------|
| 1 | 0 | 0 | 0 | 1 | Messen zwischen a-Ader und Erde |
| 1 | 0 | 0 | 1 | 1 | Messen zwischen a-Ader und b-Ader |
| 1 | 0 | 1 | 0 | 0 | Messen zwischen b-Ader und Erde |

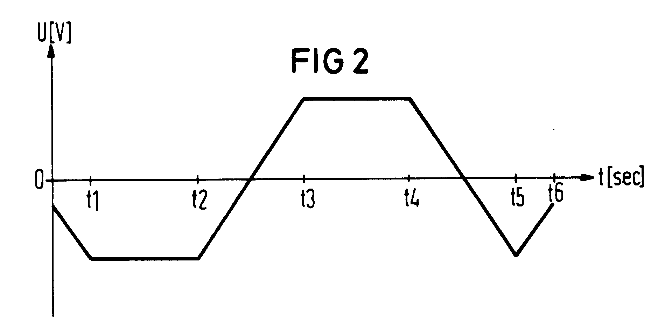

Figur 2 zeigt den zeitlichen Verlauf der Meßspannung U während der Durchführung des erfindungsgemäßen Verfahrens.

Zum Zeitpunkt t = 0 wird die Meßschaltung durch das Relais AN mit dem Meßobjekt (Teilnehmeranschlußleitung) verbunden. Zusätzlich sind z.B. die Relais S2 und S3 erregt, so daß der Betriebszustand "Messen zwischen a-Ader und b-Ader gewählt worden ist. Das Relais PA ist noch nicht erregt, was bedeutet, daß der Verstärker V über die Widerstände R5 und R6 hochohmig an die a-Ader angeschaltet ist. Nun ermittelt der Signalprozessor den Anfangswert für die Meßspannung U zum Zeitpunkt t = 0 und entscheidet, ob sich die Meßspannung im Arbeitsbereich der Meßschaltung befindet. Liegt die Meßspannung außerhalb des Arbeitsbereichs, z.B. bei Berührung einer Ader des Meßobjektes mit einer Energieversorgungsleitung, so wird die Meßschaltung vom Meßobjekt abgetrennt. Dadurch kann ein Schaden an ihr vermieden werden. Die Überschreitung des Arbeitsbereichs durch die Fremdspannung wird dabei vom Signalprozessor über den Mikrocomputer an die übergeordnete Steuerung gemeldet.

Liegt die Meßspannung U innerhalb des Arbeitsbereiches, so stellt der Signalprozessor den Verstärker V auf den ermittelten Wert der Meßspannung ein und überbrückt mit dem Relais PA den hochohmigen Schutzwiderstand R5. Nun ändert der Signalprozessor die Meßspannung U durch entsprechende Steuerung des Verstärkers V auf denjenigen Wert, der für die Widerstandsmessung im Meßauftrag vorgegeben wurde. Dabei wird mit derselben Polarität der Meßspannung begonnen, die auch die zum Zeitpunkt t = O gemessene Spannung zwischen a- und b-Ader hatte. Die Meßspannung U wird dabei mit einer definierten Flankensteilheit geändert, damit der Wecker bzw. Rufkreis im Telefon des Teilnehmers nicht anspricht.

Wenn der Verstärker V überlastet wird, z.B. durch eine direkte Berührung des Meßobjektes mit einer Nachbarader, so erkennt das der Signalprozessor durch Vergleich der normierten Meßspannung UN mit dem von ihm ausgegebenen Spannungswert für den D/A-Wandler. Auch in diesem Fall wird die Meßschaltung vom Meßobjekt abgetrennt. Dadurch kann Schaden von ihr vermieden werden. Die Fremdspannungsüberschreitung wird dabei vom Signalprozessor über den Mikrocomputer wiederum an die übergeordnete Steuerung gemeldet.

Nun beginnt über einen ersten Zeitraum tl bis t2 der erste Teil der Widerstandsmessung. Hierzu werden zwischen den Zeitpunkten t1 und t2 die Meßwerte der normierten Meßspannung UN und der proportionalen Spannung UI integriert. Nach Ablauf des ersten Zeitraums wird der Wert für den Widerstand (RX = U/I) berechnet. Dabei können die Meßwerte von zwei Störgrößen verfälscht gewesen sein. Zum einen durch eine eingekoppelte Gleichspannung, die die Meßwerte in Abhängigkeit von der Polarität der Meßspannung vergrößert oder verkleinert. Um diese Störgröße zu eliminieren, wird die Widerstandsmessung in einem zweiten Teil mit gleichem Absolutwert der Meßspannung aber umgekehrter Polarität wiederholt. Von den Meßwerten wird anschließend der arithmetische Mittelwert gebildet, so daß sich der Einfluß der eingekoppelten Gleichspannung eliminiert.

Zum anderen können die Meßwerte von einer eingekoppelten Wechselspannung verfälscht werden. Ihr Einfluß wird durch eine Integrationszeit, die ein ganzzahliges Vielfaches der Periodendauer der eingekoppelten Wechselspannung beträgt, unterbunden. Dabei wird die durch die positive Halbwelle der Wechselspannung hervorgerufene Verfälschung durch das Abwarten der negativen Halbwelle eliminiert.

Nun folgt über einen zweiten Zeitraum t2 bis t3 der erste Teil der Kapazitätsmessung. Die Kapazität wird dabei nach der Gleichung CX = I * dt/dU vom Signalprozessor berechnet, wobei dU/dt die konstante Steigung der Spannungsänderung der Meßspannung U zwischen den Zeitmarken t2 und t3 darstellt. Der zu messende Strom I ist der Strom, der durch das Meßobjekt fließt. Dabei kann er von drei Störgrößen verfälscht werden, nämlich durch eine eingekoppelte Gleichspannung, eine eingekoppelte Wechselspannung oder einen Nebenschlußwiderstand zwischen a- und b-Ader.

Die eingekoppelte Gleichspannung vergrößert oder verkleinert die Meßwerte der proportionalen Spannung UI, abhängig vom Vorzeichen der Steigung der Meßspannungsänderung. Daher wird die Kapazitätsmessung in einem zweiten Teil mit gleicher Steigung aber umgekehrten Vorzeichen wiederholt. Von den in beiden Teilen ermittelten Meßwerten der Kapazität wird anschließend der arithmetische Mittelwert gebildet, wodurch sich der Einfluß der eingekoppelten Gleichspannung eliminiert.

Der Einfluß der eingekoppelten Wechselspannung kann dadurch unterbunden werden, daß die Differenz zwischen den Ablesezeitpunkten des ersten Teiles und des zweiten Teiles der Kapazitätsmessung ein ganzzahliges Vielfaches der Periodendauer der Wechselspannung beträgt. Dabei eliminiert sich die durch die Wechselspannung hervorgerufene Verfälschung.

Der verfälschende Einfluß des Nebenschlußwiderstandes zwischen a- und b-Ader kann dadurch unterbunden werden, daß die Werte für die proportionale Spannung UI im Nulldurchgang der Meßspannung U abgelesen werden. Wenn zwischen den a- und b-Adern keine Spannungsdifferenz besteht, so kann nämlich durch einen eventuell vorhandenen Nebenschlußwiderstand auch kein Strom fließen. In der Praxis werden mehrere Werte, die symmetrisch um den Nulldurchgang liegen, abgespeichert. Davon wird dann der arithmetische Mittelwert berechnet. Dadurch werden sporadisch auftretende Störspitzen unterdrückt.

Nun folgt über einen dritten Zeitraum t3 bis t4 der zweite Teil der Widerstandsmessung. Zwischen den Zeitmarken t3 und t4 werden die Meßwerte der normierten Meßspannung UN und der proportionalen Spannung UI integriert. Nach Ablauf des dritten Zeitraums wird wiederum wie beim ersten Teil der Widerstandsmessung der Wert für den Widerstand anhand der Gleichung

RX = U/I berechnet. Abschließend wird aus den Werten für den Widerstand RX aus dem ersten und zweiten Teil der Widerstandsmessung der arithmetische Mittelwert gebildet. Dieser ist nun von Verfälschungen befreit, die von Gleich- oder Wechselspannungseinkopplungen stammen.

Nun folgt über einen vierten Zeitraum t4 bis t5 der zweite Teil der Kapazitätsmessung. Die Kapazität wird dabei vom Signalprozessor wieder nach der Gleichung CX = I * dt/dU wie im ersten Teil der Kapazitätsmessung berechnet. Anschließend wird ausd den gemessenen Kapazitätswerten des ersten und zweiten Teils der Kapazitätsmessungen der arithmetische Mittelwert gebildet. Dieser Mittelwert ist nun von Verfälschungen befreit, die von Gleich- oder Wechselspannungseinkopplungen oder von Nebenschlußwiderständen stammen.

Nun folgt über einen auf den vierten Zeitraum folgenden Zeitraum t5 bis t6 das Abschalten des Meßobjektes. Vor dem Abtrennen des Meßobjektes von der Meßschaltung werden die Kapazitäten wieder auf die gleiche Spannung aufgeladen, die sie beim Anschalten zum Zeitpunkt t = 0 hatten. Dadurch wird vermieden, daß durch Umladen der Kondensatoren beim Schaltvorgang zum Zeitpunkt t = t6 der Wecker im Telefon des Teilnehmers anspricht.

Abschließend ruft der Mikrocomputer MC die Meßergebnisse beim Signalprozessor ab und sendet sie zur übergeordneten Steuerung.

In einem an die zulässige Temperaturänderung des Systems angepaßten Zeitraster startet der Mikrocomputer einen Eichvorgang zum Abgleich des analogen Teils der Schaltungsanordnung MEQ.

Zunächst steuert der Mikrocomputer alle Relais in den Ruhezustand. Dies ist gleichbedeutend mit dem Anlegen von OV-Potential an den Eingang der Spannungsmeßschaltung und Strommeßschaltung sowie an den Ausgang des Verstärkers V. Der Signalprozessor mißt daraufhin den Offset-Wert der normierten Meßspannung UN und der proportionalen Spannung UI. Die Beendigung dieser Tätigkeit signalisiert er dem Mikrocomputer.

Der Mikrocomputer steuert daraufhin die Relais in den Eichzustand, was dem Anlegen der Eichspannung UE entspricht und veranlaßt den Signalprozessor den Eichfaktor für die normierte Meßspannung zu messen. Die Beendigung dieser Tätigkeit signalisiert der Signalprozessor wiederum dem Mikrocomputer, worauf dieser die Messung des Eichfaktors für die proportionale Spannung UI veranlaßt. Nachdem der Signal- prozessor den Eichfaktor für die proportionale Spannung ermittelt hat, signalisiert er dies wiederum dem Mikrocomputer, womit der Eichvorgang beendet ist.

Obwohl in dem erläuterten Ausführungsbeispiel nur ohm'sche und kapazitive Kenngrößen des Meßobjekts ermittelt wurden, ist es nach dem erfindungsgemäßen Verfahren selbstverständlich ebenso möglich, eine induktive Kenngröße des Meßobjekts zu ermitteln. Hierzu wird das erfindungsgemäße Verfahren mit einer rampenförmigen Beaufschlagung des Meßobjekts mit dem Strom als der einen Meßgröße und der Messung der Spannung als der anderen Meßgröße durchgeführt.

**Patentansprüche**

1. Verfahren zum Ermitteln einer elektrischen Kenngröße eines elektrischen Störgrößen ausgesetzten Meßobjekts mit Hilfe der beiden elektrischen Meßgrößen Spannung und Strom
**dadurch gekennzeichnet**, daß

a) das Meßobjekt zunächst über einen ersten Zeitraum mit einer der beiden Meßgrößen beaufschlagt und dabei die andere Meßgröße gemessen wird, wobei
b) das Meßobjekt mit der einen Meßgröße in der Weise beaufschlagt wird, daß die andere Meßgröße während des ersten Zeitraumes einen konstanten Wert annimmt,
c) aus der Art der Beaufschlagung mit der einen Meßgröße und den gemessenen Werten der anderen Meßgröße ein Wert für die elektrische Kenngröße des Meßobjekts ermittelt wird,
d) die Verfahrensschritte a) bis c) über einen zweiten Zeitraum wiederholt werden, wobei die Beaufschlagung des Meßobjekts mit der einen Meßgröße nun in der Weise erfolgt, daß die andere Meßgröße während des zweiten Zeitraums einen im Vergleich zum ersten Zeitraum gleich großen Wert, jedoch mit entgegengesetzter Polarität annimmt,

**EP 0 580 947 B1**

e) schließlich aus den zwei ermittelten Werten für die elektrische Kenngröße der arithmetische Mittelwert gebildet wird.

2. Verfahren nach Anspruch 1,
   **dadurch gekennzeichnet**, daß zum Ermitteln einer ohm'schen Kenngröße eine konstante Beaufschlagung des Meßobjekts mit der einen Meßgröße angewandt wird.

3. Verfahren nach Anspruch 1,
   **dadurch gekennzeichnet**, daß zum Ermitteln einer kapazitiven Kenngröße eine rampenförmige Beaufschlagung des Meßobjekts mit der Spannung als der einen Meßgröße angewandt wird.

4. Verfahren nach Anspruch 1,
   **dadurch gekennzeichnet**, daß zum Ermitteln einer induktiven Kenngröße eine rampenförmige Beaufschlagung des Meßobjekts mit dem Strom als der einen Meßgröße angewandt wird.

5. Verfahren nach Anspruch 2,
   **dadurch gekennzeichnet**, daß die Meßwerte der anderen Meßgröße über den jeweiligen Meßzeitraum integriert werden, wobei der Meßzeitraum ein ganzzahliges Vielfaches der Periodendauer der eingekoppelten Wechselspannung beträgt.

6. Verfahren nach Anspruch 3,
   **dadurch gekennzeichnet**, daß die Differenz zwischen den Meßzeitpunkten des ersten Teiles und des zweiten Teiles der Messung ein ganzzahliges Vielfaches der Periodendauer der Wechselspannung beträgt.

**Claims**

1. Method for determining an electrical characteristic of a measurement object which is subject to electrical disturbance variables, with the aid of the two electrical measurement variables voltage and current, characterized in that

   a) the measurement object first of all has one of the two measurement variables applied to it for a first time period and the other measurement variable is measured at the same time,
   b) the measurement object having the first measurement variable applied to it in such a manner that the other measurement variable assumes a constant value during the first time period,
   c) a value for the electrical characteristic of the measurement object is determined from the way in which the first measurement variable is applied and from the measured values of the other measurement variable,
   d) method steps a) to c) are repeated for a second time period, the first measurement variable now being applied to the measurement object in such a manner that the other measurement variable assumes a value during the second time period which is equal to that in the first time period, but is of opposite polarity,
   e) finally, the arithmetic mean is formed from the two values determined for the electrical characteristic.

2. Method according to Claim 1, characterized in that the first measurement variable is applied to the measurement object in a constant manner in order to determine a resistive characteristic.

3. Method according to Claim 1, characterized in that, using voltage as the first measurement variable, a ramp voltage is applied to the measurement object in order to determine a capacitive characteristic.

4. Method according to Claim 1, characterized in that, using current as the first measurement variable, a ramp current is applied to the measurement object in order to determine a inductive characteristic.

5. Method according to Claim 2, characterized in that the measured values of the other measurement variable are integrated over the respective measurement time period, the measurement time period being an integer multiple of the duration of one cycle of the injected AC voltage.

6. Method according to Claim 3, characterized in that the difference between the measurement instants for the first part and the second part of the measurement is an integer multiple of the duration of one cycle of the AC voltage.

6

**Revendications**

1. Procédé de détermination d'une grandeur électrique caractéristique d'un objet de mesure exposé à des grandeurs électriques parasites, à l'aide des deux grandeurs électriques de mesure que sont la tension et le courant caractérisé par le fait que

   a) l'objet de mesure est dans un premier laps de temps alimenté par l'une des deux grandeurs de mesure, et pendant ce temps l'autre grandeur de mesure est mesurée,
   b) l'objet de mesure étant alimenté par l'une des grandeurs de mesure de telle sorte que l'autre grandeur de mesure prenne une valeur constante pendant le premier laps de temps,
   c) une valeur pour la grandeur électrique caractéristique de l'objet de mesure est déterminée à partir du mode d'alimentation par l'une des grandeurs de mesure et des valeurs mesurées de l'autre grandeur de mesure,
   d) les phases de procédé a) à c) sont répétées dans un deuxième laps de temps, l'alimentation de l'objet de mesure par l'une des grandeurs de mesure étant alors effectuée de telle sorte que l'autre grandeur de mesure prenne durant ce deuxième laps de temps la même valeur que dans le premier laps de temps, mais avec une polarité inverse,
   e) pour finir, la valeur moyenne arithmétique est calculée à partir des deux valeurs déterminées pour la grandeur électrique caractéristique.

2. Procédé selon la revendication 1,
   caractérisé par le fait que, pour déterminer une grandeur ohmique caractéristique, l'objet de mesure est alimenté de façon constante par l'une des grandeurs de mesure.

3. Procédé selon la revendication 1,
   caractérisé par le fait que, pour déterminer une grandeur capacitive caractéristique, l'objet de mesure est alimenté en forme de rampe par la tension en tant que l'une des grandeurs de mesure.

4. Procédé selon la revendication 1,
   caractérisé par le fait que, pour déterminer une grandeur inductive caractéristique, l'objet de mesure est alimenté en forme de rampe par le courant en tant que l'une des grandeurs de mesure.

5. Procédé selon la revendication 2,
   caractérisé par le fait que les valeurs de mesure de l'autre grandeur de mesure sont intégrées pendant le laps de temps de mesure respectif, le laps de temps de mesure étant égal à un multiple entier de la durée d'une période de la tension alternative induite par couplage.

6. Procédé selon la revendication 3,
   caractérisé par le fait que la différence entre les instants de mesure de la première partie et de la deuxième partie de la mesure est égale à un multiple entier de la durée d'une période de la tension alternative.

FIG1

TE  ZL  MEQ

EP 0 580 947 B1

FIG 2